# EUROPEAN PATENT APPLICATION

(11) **EP 4 068 340 A1**
(43) Date of publication of application: **05.10.2022**
(21) Application number: 21863293.3
(22) Date of filing: 08.06.2021
(51) Int. Cl.: H01L 21/48

(54) **PREPARATION METHOD FOR METAL CONNECTION LINE**

(30) Priority: 03.09.2020 CN 202010914670
(71) Applicant: Changxin Memory Technologies, Inc., Hefei City, Anhui 230601 (CN)
(72) Inventor: XI, Ning, Hefei City, Anhui 230601 (CN); PAN, Junbo, Hefei City, Anhui 230601 (CN)
(74) Representative: Lavoix
(86) International application number: PCT/CN2021/098965
(87) International publication number: WO 2022/048224

(57) **Abstract**

A preparation method of a metal connecting line includes: providing a base, where the base includes a metal conductive structure; patterned etching the base to expose a surface of the metal conductive structure; treating a surface of the base by oxygen-containing plasma to remove a charge on the surface of the metal conductive structure; and cleaning the surface of the metal conductive structure by hydrogen.

## Description

### Cross-Reference to Related Applications

The present disclosure claims the priority to Chinese Patent Application No. 202010914670.X, titled "PREPARATION METHOD OF METAL CONNECTING LINE", filed on September 3, 2020, which is incorporated herein by reference in its entirety.

### Technical Field

The present disclosure relates to the technical field of semiconductor preparation, and in particular to a preparation method of a metal connecting line.

### Background

A plasma process is used in the manufacturing process of a chip, and after a base is etched by plasma, charges are usually left on a metal connecting line of the base. The residual charges can affect the performance of a semiconductor device, or even arc discharge can occur in the manufacturing process of the chip, so that the chip is scrapped.

### Summary

A major objective of the present disclosure is to provide a preparation method of a metal connecting line, which can effectively remove a residual charge on a surface of a base without damaging the surface of the base.

In order to achieve the above objective, for an aspect of the present disclosure, a preparation method of a metal connecting line is provided, the preparation method of a metal connecting line includes: providing a base, where the base includes a metal conductive structure; patterned etching the base to expose a surface of the metal conductive structure; treating a surface of the base by oxygen-containing plasma to remove a charge on the surface of the metal conductive structure; and cleaning the surface of the metal conductive structure by hydrogen.

According to an embodiment of the present disclosure, a metal oxide layer is formed on the surface of the base after the surface of the base is treated by the oxygen-containing plasma.

According to an embodiment of the present disclosure, the hydrogen is hydrogen plasma so as to reduce the metal oxide layer.

According to an embodiment of the present disclosure, a temperature of reducing the metal oxide layer by the hydrogen plasma is 15 °C -35 °C.

According to an embodiment of the present disclosure, an environment where the base is located is vacuumized, before the metal oxide layer is reduced by the hydrogen plasma.

According to an embodiment of the present disclosure, the hydrogen is at a high-temperature so as to reduce the metal oxide layer, and the high temperature is 500°C-1100°C.

According to an embodiment of the present disclosure, a thickness of the metal oxide layer is less than 1 nm.

According to an embodiment of the present disclosure, a temperature of etching the base by the oxygen-containing plasma is 15°C-35°C.

According to an embodiment of the present disclosure, an environment where the base is located is vacuumized before the surface of the base is treated by the oxygen-containing plasma.

According to an embodiment of the present disclosure, the step of forming the base includes: forming a first insulating layer, the metal conductive structure and a covering layer on a substrate, wherein the first insulating layer, the metal conductive structure and the covering layer are stacked sequentially; and forming a hard mask layer on the covering layer.

It can be seen from the above technical solutions that the present disclosure has at least one of the following advantages and positive effects:
the surface of the base is treated by the oxygen-containing plasma, so that the charge on the surface of the conductive structure can be neutralized. The surface of the conductive structure is cleaned by the hydrogen, so that the neutralized charge and other impurities can be completely removed without damaging the surface of the base.

### Brief Description of the Drawings

The above and other features and advantages of the present disclosure will become more apparent by describing in detail exemplary embodiments thereof with reference to the accompanying drawings.
FIG. 1 is a schematic diagram of a base with a residual charge attached in the prior art.
FIG. 2 is a schematic diagram of a base with a residual charge on the base removed by hydrogen and nitrogen in the prior art.
FIG. 3 is a schematic diagram of treating a base with a residual charge by oxygen-containing plasma in an embodiment of the present disclosure.
FIG. 4 is a schematic diagram of a surface of a base with a metal oxide layer formed in an embodiment of the present disclosure.
FIG. 5 is a schematic diagram of reducing a metal oxide layer by hydrogen in an embodiment of the present disclosure.
FIG. 6 is a schematic diagram of a base with an oxide layer reduced in an embodiment of the present disclosure.
FIG. 7 is a schematic diagram of treating a base with a residual charge by oxygen-containing plasma in another embodiment of the present disclosure.
FIG. 8 is a schematic diagram of a surface of a base with a metal oxide layer formed in another embodiment of the present disclosure.
FIG. 9 is a schematic diagram of reducing a metal oxide layer by hydrogen in another embodiment of the present disclosure.
FIG. 10 is schematic diagram of a base with an oxide layer reduced in another embodiment of the present disclosure.

Reference numerals are as follows: 1, base; 11, substrate; 12, insulating layer; 13, metal conductive structure layer; 13', metal connecting line, 2, charge; 3, metal oxide layer.

### Detailed Description

Exemplary embodiments will now be described more fully with reference to the accompanying drawings. However, the exemplary embodiments can be implemented in a variety of forms and should not be construed as limited to the embodiments set forth herein; rather, these embodiments are provided so that the present disclosure will be thorough and complete, and will fully convey the concept of the exemplary embodiments to those skilled in the art. The same reference numerals in the drawings denote the same or similar structures, and thus their detailed description will be omitted.

In the following description of various embodiments of the present disclosure, reference is made to the accompanying drawings, which form a part hereof, and in which is shown by way of example various exemplary structures in which aspects of the disclosure may be practiced. It should be understood that other specific solutions of components, structures, exemplary devices, systems, and steps may be used, and structural and functional modifications may be made without departing from the scope of the present disclosure. Moreover, although the terms "above," "between," "within," and the like may be used in this specification to describe various exemplary features and elements of the present disclosure, these terms are used herein for convenience only, e.g., in accordance with the orientation of the examples in the accompanying drawings. Nothing in this specification should be construed as requiring a particular three-dimensional orientation of the structure to fall within the scope of the present disclosure. Furthermore, the terms "first," "second," and the like in the claims are used merely as labels and not as numerical limitations on their objects.

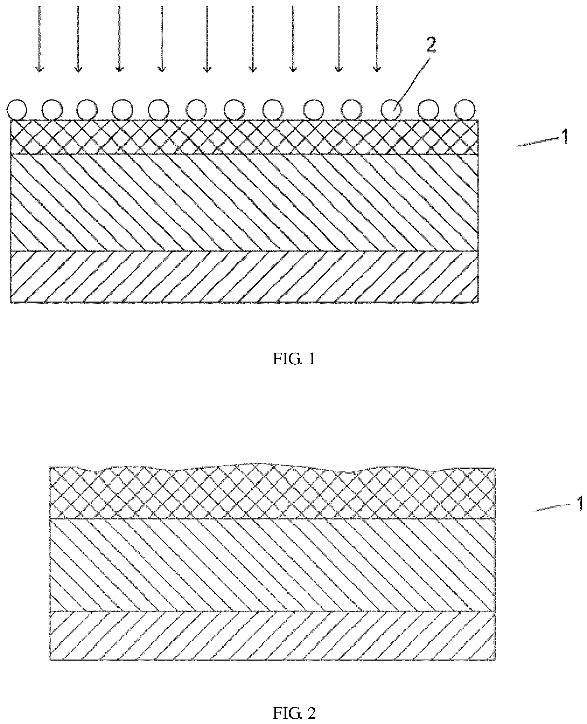

Researchers have found that a charge is left on a base 1 during the preparation of a semiconductor metal connecting line. FIG. 1 shows a schematic diagram of the semiconductor base 1 with a residual charge. In order to solve this problem, those skilled have tried to remove the residual charge by plasma of a mixed gas of hydrogen and nitrogen to prevent the base 1 from being oxidized. However, in the process of removing the residual charge, it was found that this method easily damages the surface of the base 1 to form defects on the surface of the base 1.

In order to completely remove the residual charge without damaging the base 1, the present disclosure provides a preparation method of a metal connecting line for preparing a metal connecting line in a semiconductor. The preparation method of the metal connecting line includes: forming an insulating layer 12 and a metal conductive structure on a semiconductor substrate 11, the insulating layer 12 and the metal conductive structure being stacked sequentially, forming a hard mask layer on the metal conductive structure, forming a photoresist layer on the hard mask layer, etching the photoresist to form a pattern, transferring the pattern to the hard mask layer, etching the metal conductive structure through an etching process by the pattern of the hard mask layer to form the metal connecting line, then removing the hard mask layer, and forming another insulating layer 12 on the semiconductor substrate 11 including the metal connecting line, to insulate metal connecting lines from each other.

In some embodiments of the present disclosure, a predetermined isolation layer, transistor, source contact plug, etc. may be formed on the substrate 11, followed by forming an insulating layer 12 thereon, and then the insulating layer 12 is etched to form a contact hole (not shown). To reduce contact resistance, an ion implantation process is performed to form a junction region in the semiconductor substrate 11. A metal barrier layer is formed in the contact hole, and then a conductive layer is formed on the semiconductor substrate 11 including the contact hole to fill the contact hole (not shown). The metal conductive structure, which may include a metal conductive layer and a barrier metal layer, is then sequentially formed on the insulating layer 12. Subsequently, the hard mask layer and the photoresist layer are formed on the metal conductive structure. The photoresist layer is etched through an exposure process and a development process to form a photoresist pattern, and then the hard mask layer is etched through the photoresist pattern as an etching mask. The metal conductive structure is etched by the photoresist pattern and the etched hard mask layer as an etching mask to form the metal line.

In some embodiments of the present disclosure, the hard mask layer is typically formed from an amorphous carbon layer and an oxynitride silicon layer. The metal conductive structure may be formed from metal tungsten. The etching process may be a plasma process.

Another insulating layer may be formed by sputtering, and is preferably formed from a high density plasma (HDP) oxide layer.

In the above preparation method, some impurities (such as some organic matters) and a charge 2 are usually left on a surface of the metal conductive structure, and on the basis of the above preparation steps, these residual impurities and charge 2 cannot be removed.

According to the preparation method of the metal connecting line, on the basis of the above preparation method, the residual impurities and charge 2 on the etched base 1 of the semiconductor device can be effectively removed.

The method of the present disclosure includes: providing the above base 1, where the base 1 includes the metal conductive structure; patterned etching the base 1 to expose the surface of the metal conductive structure; treating a surface of the base 1 by oxygen-containing plasma to remove the charge 2 on the surface of the metal conductive structure; and cleaning the surface of the metal conductive structure by hydrogen.

The surface of the base 1 is treated by the oxygen-containing plasma, so that the charge 2 on the surface of the conductive structure can be neutralized. The surface of the conductive structure is cleaned by the hydrogen, so that the charge 2 and other impurities can be completely removed, and the surface of the base 1 can not be damaged.

The preparation method of the metal connecting line of the present disclosure is described in detail below.

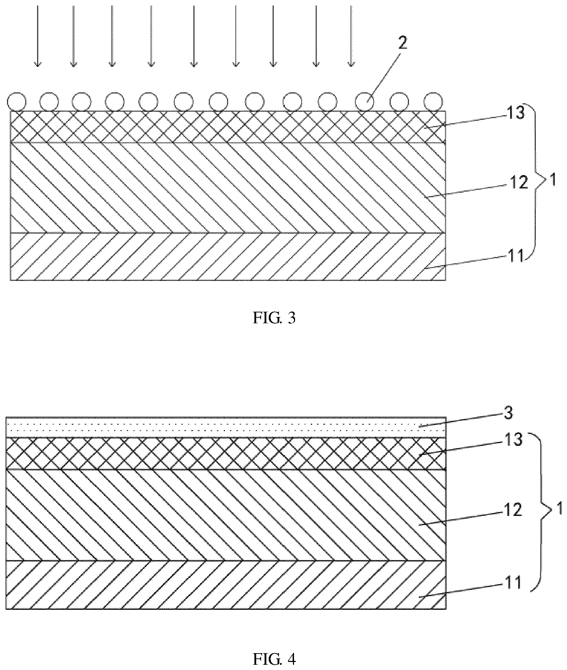

In some embodiments, refer to FIGS. 3 to 6, which respectively show schematic structural diagrams of a base 1 including a substrate 11, an insulating layer 12 and a metal conductive structure layer 13. The metal conductive structure layer 13 in this embodiment has not been etched through a hard mask layer but is only exposed to the base 1. As shown in FIG. 3, a charge tends to be left on a surface of the exposed metal conductive structure layer 13.

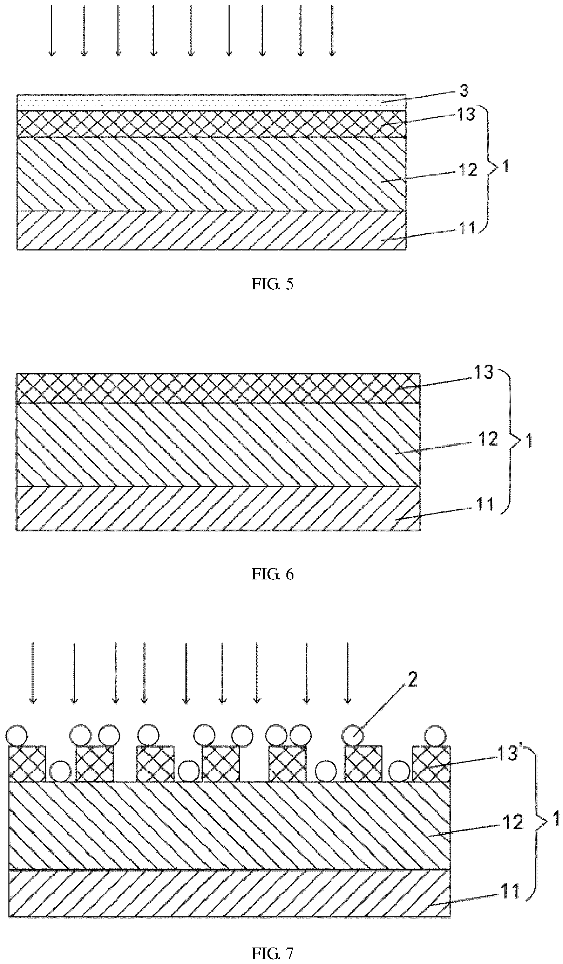

Refer to FIGS. 3 to 6, FIG. 3 shows a schematic diagram of treating the base with a residual charge 2 by oxygen-containing plasma in the method of the present disclosure. FIG. 4 shows a schematic diagram of forming a metal oxide layer 3 after treating the surface of the metal conductive structure layer 13 by oxygen-containing plasma. FIG. 5 shows a schematic diagram of reducing the metal oxide layer by hydrogen. FIG. 6 shows a schematic diagram of the base with the metal oxide layer 3 reduced, and a schematic diagram of a surface of the base 1 with the residual charge on the surface of the metal conductive structure layer 13 removed.

The method of the present disclosure combines various schematic diagrams as follows: as shown in FIG. 3, the surface of the metal conductive structure layer 13 is treated by the oxygen-containing plasma. As shown in FIG. 4, the oxygen-containing plasma forms the metal oxide layer 3 on the surface of the metal conductive structure layer 13 by the residual charge 2. As shown in FIG. 5, the surface of the metal conductive structure layer 13 is cleaned by hydrogen, that is, the metal oxide layer 3 is reduced in-situ to remove the original residual charge 2.

In other embodiments, refer to FIGS. 7 to 9, which show schematic structural diagrams of a base 1 including a substrate 11, an insulating layer 12 and a metal connecting line 13', respectively. In this embodiment, the metal conductive structure layer 13 is etched by a hard mask layer to form the metal connecting line 13' with a pattern. As shown in FIG. 7, a charge is left on the etched metal connecting line 13'.

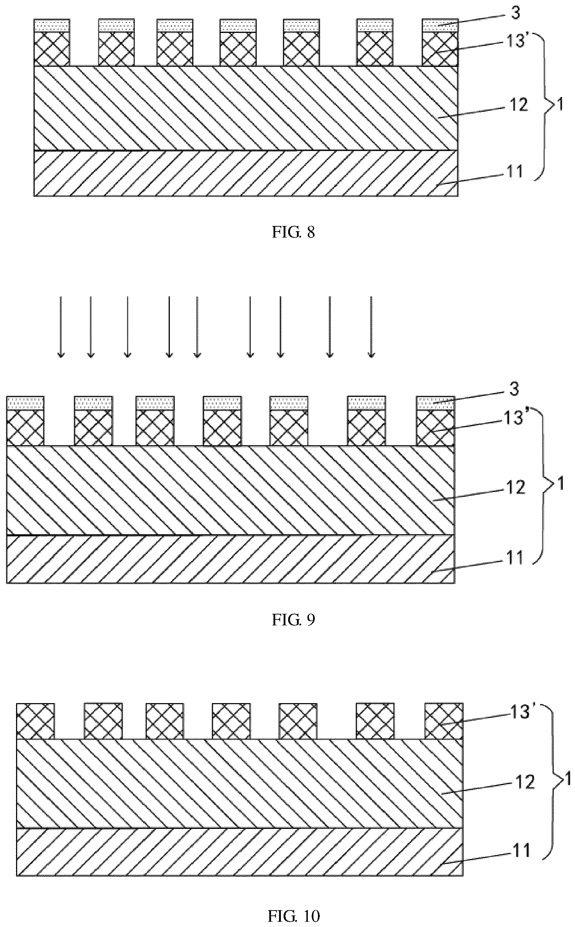

Refer to FIGS. 7 to 10, FIG. 7 shows a schematic diagram of treating a residual charge 2 on a surface of the metal connecting line 13' by oxygen-containing plasma in the method of the present disclosure. FIG. 8 shows a schematic diagram of forming a metal oxide layer 3 on the surface of the metal connecting line 13'. FIG. 9 shows a schematic diagram of reducing the metal oxide layer 3 by hydrogen. FIG. 10 shows a schematic diagram of the base 1 with the metal oxide layer 3 reduced.

The method of the present disclosure combines various schematic diagrams as follows: as shown in FIG. 7, the surface of the metal connecting line 13' is treated by the oxygen-containing plasma. As shown in FIG. 8, the oxygen-containing plasma forms the metal oxide layer 3 on the surface of the metal connecting line 13' by the residual charge 2. As shown in FIG. 9, the surface of the metal connecting line 13' is cleaned by hydrogen, that is, the metal oxide layer 3 is reduced in-situ to remove the original residual charge 2.

Therefore, the method of the present disclosure can not only remove the residual charge of the unpatterned metal conductive structure layer 13, but also further remove the residual charge on the surface of the patterned metal connecting line 13' in the process of preparing the metal connecting line 13'.

The metal conductive structure layer 13 and the metal connecting line 13' in the above embodiments of the present disclosure may be collectively referred to as a metal conductive structure.

The material of the substrate 11 in the above embodiments of the present disclosure may be silicon, silicon carbide, silicon nitride, silicon-on-insulator, stacked silicon-on-insulator, stacked silicon germanium-on-insulator, silicon germanium-on-insulator, germanium-on-insulator, or the like.

In some embodiments of the present disclosure, the residual impurities may include organic impurities. The organic impurities may be, for example, polymers generated during plasma etching, such as etching the hard mask layer by plasma. The hard mask layer generally is silicon oxide, silicon nitride, polysilicon or other materials and combinations thereof, which may leave organic impurities on the base 1 after plasma etching. A wafer can also be etched by plasma, the etching gas can be Cl₂, BCl₃, CCl₄, NF₃, SF₆, CF₄ and the like. Impurities such as organic matters and the like are also easily generated to be left on a surface of the etched wafer in this etching process. In addition, the charge 2 is also accumulated in the plasma etching process, which can be a positive ion and an electron. The probability of the electron striking the base 1 is greater than that of the positive ion. Due to the high reaction characteristics thereof, the electron is more easily absorbed by the surface of the base 1, causing accumulation of the charge 2, especially when the base 1 is exposed to the surface of the metal conductive structure. According to the preparation method of the metal connecting line disclosed by the present disclosure, the residual impurities and the charge 2 can be effectively removed, and damage to a semiconductor device is avoided.

In some embodiments, as shown in FIGS. 3 and 7, when the surface of the base 1 with the residual charge 2 is treated by the oxygen-containing plasma, since the oxygen-containing plasma has a high activity, treatment can be performed in an ambient temperature environment, for example, at a temperature of 15°C-50°C, may be 20°C, 25°C, 30°C, or 40°C, etc. As shown in FIGS. 4 and 8, the oxygen-containing plasma can oxidize the surface of the metal conductive structure, so that the metal oxide layer 3 is formed on the surface of the metal conductive structure of the base 1. When the surface of the metal conductive structure is oxidized, the residual charge 2, the plasma and the charge 2 distribution among metal elements can be utilized to generate a stable metal oxide, so that the neutralization effect on the residual charge 2 is realized, and the residual charge 2 is transferred into the stable metal oxide.

The oxygen-containing plasma is provided by a plasma generating device, and the supply amount of the oxygen-containing plasma can be controlled by controlling the plasma generating device. The plasma generating device is mature prior art in the field and is commercially available, so that the present disclosure does not describe in detail the structure and operating principles thereof.

In some embodiments, by controlling an amount of oxygen plasma, a thickness of the metal oxide layer 3 can be controlled. In the disclosed embodiment, the thickness of the metal oxide layer 3 is less than 1 nm, for example, 0.5 nm, 0.6 nm, 0.8 nm, etc., and is not limited thereto. The thickness of the metal oxide layer 3 is controlled to be less than 1 nm to prevent the problems that the thickness of the metal oxide layer 3 is too thick, the metal oxide is not easy to completely remove when hydrogen is used for subsequent cleaning, equipment loss and energy consumption are increased, and environmental protection is not facilitated.

In some embodiments, in order to ensure the effective etching of the plasma, before the surface of the base 1 is treated by the oxygen-containing plasma, the environment where the base 1 is located is vacuumized, that is, the base 1 is subjected to the plasma treatment under the vacuum environment, so that the influence of other impurities on the treatment process is avoided, and it is ensured that all the residual charge 2 can be removed.

In some embodiments, as shown in FIGS. 5 and 9, the surface of the conductive structure is cleaned by the hydrogen in the embodiment of the present disclosure, and specifically, the metal oxide layer 3 in the above embodiment is reduced in-situ by the hydrogen. A chemical equation for its reduction can be expressed as: MₓO_{y}+H₂=M+H₂O+O₂, where *M* represents a metal element of the metal conductive structure. Through the in-situ reduction for the metal oxide layer 3, the metal oxide is reduced into a metal simple substance, other elements generate water and oxygen, and water and oxygen can be easily separated from the metal conductive structure, so that the surface of the metal conductive structure is easily cleaned, and the metal conductive structure can be thoroughly cleaned.

In some embodiments, when the metal oxide layer 3 is reduced, the introduced hydrogen may be hydrogen plasma.

The hydrogen plasma may be provided by the plasma generating device. Moreover, an amount of the hydrogen plasma can be controlled according to the amount of the oxygen-containing plasma. On the basis that the metal oxide layer 3 can be completely reduced, the energy consumption is saved, and the cost is reduced.

In some embodiments, since the hydrogen plasma is very active, the metal oxide layer 3 can be rapidly reduced to metal at a normal temperature, for example, 15°C-50°C, specifically, may be 20°C, 25°C, 30°C, or 40°C, and the like. Reduction by the hydrogen plasma can reduce loss, moreover can be easy to realize under a low-temperature condition, and reduces operation difficulty. As shown in FIGS. 6 and 10, since the metal oxide layer 3 is reduced to the metal in-situ without damaging the metal conductive structure, the process does not damage the surface of the base 1 on the basis of removing the residual charge 2.

In some embodiments, before the metal oxide layer 3 is reduced by the hydrogen plasma, the environment where the base 1 is located is vacuumized. In other words, the base 1 is subjected to plasma cleaning in a vacuum environment, so that the influence of other impurities on the cleaning process is avoided, and the metal oxide layer 3 can be completely reduced without generating other impurities.

In some embodiments, as shown in FIGS. 5 and 10, the hydrogen of the embodiment of the present disclosure may also be hydrogen in a high temperature environment rather than hydrogen plasma. The metal oxide layer 3 can also be reduced in-situ by hydrogen. In addition, hydrogen has strong activity at high temperature, and can rapidly reduce the metal oxide layer 3. The chemical reaction equation is the same as above except that the condition is high temperature and will not be described in detail here.

The metal oxide layer 3 is reduced by hydrogen at a high temperature, in which case the temperature at the high temperature may be 500°C-1100°C, specifically, may be 600°C, 700°C, 800°C, 900°C or 1000°C, etc. Those skilled in the art would be able to adjust the temperature according to actual circumstances, for example, according to the specific thickness of the metal oxide layer 3. Also, since the metal oxide layer 3 is reduced to the metal in-situ, as shown in FIGS. 8 to 10, the surface of the metal conductive structure is not damaged, and the surface of the base 1 is not damaged.

The content of the hydrogen at a high temperature can also be controlled according to the oxygen content of the oxygen-containing plasma in the above mentioned embodiment, or the surface of the base 1 can be checked at any time after a certain amount of hydrogen is introduced. If it is checked that metal oxide remains, a proper amount of hydrogen may continue to be introduced to continue the reaction. Those skilled in the art can perform operation according to practical situations, and no special restrictions are made here.

In addition, in order to avoid introducing other impurities or generating new impurities in the reaction process, the introduced hydrogen is pure hydrogen, that is, the introduced gas cannot contain other hydrogen or impurities. For example, it is possible to vacuumize the environment where the base 1 is located before introducing hydrogen, or to initially charge pure hydrogen in a low-temperature environment, discharge air and other impurities in the environment where the base 1 is located, raise the temperature when a pure hydrogen environment is detected, and continue introducing hydrogen for reaction. Thus, the metal conductive structure can be protected from being damaged, and the stability of the metal connecting line 13' is ensured.

In combination with the preparation method of the metal connecting line in the above embodiment of the present disclosure, the preparation method of the metal connecting line of the present disclosure may include: forming the insulating layer 12 and the metal conductive structure on the semiconductor substrate 11, the insulating layer and the metal conductive structure being stacked sequentially, and sequentially forming the hard mask layer and the photoresist layer on the metal conductive structure; etching the photoresist to form a pattern, transferring the pattern to the hard mask layer, etching the metal conductive structure through the etching process by the pattern of the hard mask layer to form the metal connecting line 13', and then removing the hard mask layer, that is, patterned etching the base 1 to expose the surface of the metal conductive structure; treating the surface of the base 1 by the oxygen-containing plasma, removing the residual charge 2 on the surface of the conductive structure, that is, neutralizing the residual charge 2 by the oxygen-containing plasma, and forming the metal oxide layer 3 on the surface of the base 1; cleaning the surface of the conductive structure by hydrogen, that is, reducing the metal oxide layer 3 in-situ by hydrogen; and forming another insulating layer on the semiconductor substrate 11 including the metal connecting line 13' to insulate metal connecting lines 13' from one another.

It should be noted that, when cleaning is performed by the hydrogen plasma or the hydrogen at a high temperature, not only can the metal oxide layer 3 be reduced to remove the residual charge 2, but also the residual organic impurities can be removed at the same time due to its strong reducibility.

In summary, in the preparation method of the metal connecting line of the present disclosure, the surface of the base 1 is treated by the oxygen-containing plasma, so that the charge 2 on the surface of the conductive structure can be neutralized. The surface of the conductive structure is cleaned by the hydrogen, so that the neutralized charge 2 and other impurities can be completely removed without damaging the surface of the base 1.

It should be understood that the present disclosure does not limit its application to the detailed structure and arrangement of the components presented in this specification. The present disclosure can have other embodiments and can be implemented and executed in a variety of ways. The forgoing forms of variations and modifications are within the scope of the present disclosure. It should be understood that the present disclosure as disclosed and defined in this specification extends to all alternative combinations of two or more of the individual features mentioned or evident in the text and/or accompanying drawings. All of these different combinations constitute a number of alternative aspects of the present disclosure. The embodiments described in this specification illustrate the best modes known for practicing the present disclosure and will enable those skilled in the art to utilize the present disclosure.

## Claims

1. A preparation method of a metal connecting line, comprising:
providing a base, wherein the base comprises a metal conductive structure;
patterned etching the base to expose a surface of the metal conductive structure;
treating a surface of the base by oxygen-containing plasma, to remove a charge on the surface of the metal conductive structure; and
cleaning the surface of the metal conductive structure by hydrogen.

2. The preparation method of the metal connecting line according to claim 1, wherein a metal oxide layer is formed on the surface of the base, after the surface of the base is treated by the oxygen-containing plasma.

3. The preparation method of the metal connecting line according to claim 2, wherein the hydrogen is hydrogen plasma, so as to reduce the metal oxide layer.

4. The preparation method of the metal connecting line according to claim 3, wherein a temperature of reducing the metal oxide layer by the hydrogen plasma is 15°C-50°C.

5. The preparation method of the metal connecting line according to claim 3, wherein an environment where the base is located is vacuumized, before the metal oxide layer is reduced by the hydrogen plasma.

6. The preparation method of the metal connecting line according to claim 2, wherein the hydrogen is at a high-temperature so as to reduce the metal oxide layer, and the high temperature is 500°C -1100°C .

7. The preparation method of the metal connecting line according to claim 2, wherein a thickness of the metal oxide layer is less than 1 nm.

8. The preparation method of the metal connecting line according to claim 1, wherein a temperature of etching the base by the oxygen-containing plasma is 15°C-50°C.

9. The preparation method of the metal connecting line according to claim 1, wherein an environment where the base is located is vacuumized, before the surface of the base is treated by the oxygen-containing plasma.

10. The preparation method of the metal connecting line according to any one of claims 1 to 9, wherein the step of forming the base comprises:
forming an insulating layer and the metal conductive structure on a substrate, the insulating layer and the metal conductive structure being stacked sequentially; and
sequentially forming a hard mask layer and a photoresist layer on the metal conductive structure.
